Europäisches Patentamt

European Patent Office

Office européen des brevets

(11) Numéro de publication : **0 003 926**
**B1**

(12) **FASCICULE DE BREVET EUROPÉEN**

(45) Date de publication du fascicule du brevet :
30.09.81

(51) Int. Cl.³ : **H 01 L 21/225, H 01 L 29/78**

(21) Numéro de dépôt : **79400084.4**

(22) Date de dépôt : **08.02.79**

(54) **Procédé de réalisation d'un transistor à effet de champ à grille isolée.**

(30) Priorité : **17.02.78 FR 7804528**

(43) Date de publication de la demande :
**05.09.79 (Bulletin 79/18)**

(45) Mention de la délivrance du brevet :
**30.09.81 Bulletin 81/39**

(84) Etats contractants désignés :
**BE DE GB NL**

(56) Documents cités :
**FR - A - 2 143 418**
**FR - A - 2 293 796**
**US - A - 3 895 978**

**IBM TECHNICAL DISCLOSURE BULLETIN**
**Vol. 2, nr. 1, juin 1977 ; New York**
**I.T. HO et al. : « Doped polysilicon diffusion**
**source and its application in single electrode**
**random access memories », pages 146-148.**

(73) Titulaire : **THOMSON-CSF**
**173, Boulevard Haussmann**
**F-75360 Paris Cedex 08 (FR)**

(72) Inventeur : **Gilles, Jean**
**"THOMSON-CSF" - SCPI 173, bld Haussmann**
**F-75360 Paris Cedex 08 (FR)**

(74) Mandataire : **Favre, Maurice et al**
**"THOMSON-CSF" - SCPI 173, bld Haussmann**
**F-75360 Paris Cedex 08 (FR)**

Il est rappelé que : Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

Imprimerie Jouve, 17, rue du Louvre, 75001 Paris, France

## Procédé de réalisation d'un transistor à effet de champ à grille isolée

La présente invention se rapporte à un procédé de réalisation d'un transistor à effet de champ à grille isolée, transistor du type comportant une région de source avec son électrode de contact, une région de drain avec son électrode de contact et une région de canal avec une grille de commande isolée par une couche d'oxyde d'isolation de grille au-dessus de la région de canal, procédé qui comporte une étape de création simultanée des régions de source et de drain, par diffusion d'impuretés de dopage incluses dans les électrodes de contact.

La mise en œuvre en nombre croissant de tels transistors, en particulier dans la constitution de circuits électroniques de mémoires, a conduit à la recherche continue d'une diminution de leurs dimensions, particulièrement pour satisfaire aux exigences de l'intégration monolithique en très grande échelle, et a rendu nécessaire l'adoption de procédés de réalisation rendant de plus en plus précise la délimitation des diverses zones de la surface du substrat de semiconducteur où les transistors sont créés.

Les procédés de photo-masquage habituellement mis en œuvre trouvent leurs limites lorsque des dimensions, pour une électrode donnée, de l'ordre du millième de millimètre sont nécessaires. Le problème à la base de l'invention est de substituer à ces procédés de photo-masquage, un procédé de création de régions de dimensions minuscules qui bénéficient d'un autopositionnement par rapport à des régions aisées à mettre en place en premier lieu.

La solution de ce problème consiste en ce que l'une des électrodes de contact comprend des impuretés des deux types de conductivité, et que l'étape de diffusion a une durée déterminée, assurant par différence des vitesses de diffusion des impuretés des deux types, la définition de la longueur (L) d'une partie diffusée du canal, partie qui, en liaison avec la grille de commande, contrôle essentiellement le passage du courant.

L'invention consiste donc essentiellement en un procédé de fabrication d'un transistor à effet de champ à grille isolée où d'une part la longueur du canal est définie par diffusion à partir de régions dopées du substrat, et d'autre part les prises de contact sont assurées par des couches d'un matériau qui a servi de source d'impuretés pour la création de ces régions.

Les types de conductivité respectifs de ces régions dopées et du canal auquel elles donnent naissance devant être, comme il est connu dans les transistors à effet de champ, de signes opposés, il est essentiel de remarquer que, à titre de caractéristique importante de l'invention, un double dopage simultané par les deux impuretés nécessaires est effectué lors de la création d'une des régions dopées, la différence entre leurs vitesses respectives de diffusion assurant, par un mécanisme de différence géométrique, la création de la région du canal.

Il est connu du journal « IBM - Technical Disclosure Bulletin », vol. 20, N° 1, June 1977, pages 146-148 le préambule de la revendication 1, que les électrodes de contact sont constituées de silicium polycristallin, et que l'on peut doper le silicium polycristallin avec des impuretés de l'un et/ou l'autre type, par exemple avec du bore et/ou de l'arsenic. Il est connu du FR-A-2 293 796 qu'un procédé de réalisation d'un transistor à effet de champ comporte une étape de réalisation de grille de commande par dépôt de silicium polycristallin.

Une telle mise en œuvre est, selon un mode particulier de réalisation de l'invention, exploitée aussi bien dans la création des régions de drain et de source des transistors, à partir d'une source d'impuretés de dopage constituée par un dépôt de silicium polycristallin, que dans la création du canal et la définition de sa longueur précise, à partir de la région de source, par un mécanisme de double diffusion simultanée à profondeurs contrôlées.

Des réductions de dimensions notables par rapport aux techniques connues de photo-masquage sont alors obtenues, avec des longueurs typiques de canal de l'ordre du millième de millimètre seulement.

Par ailleurs, un autre problème prend une importance croissante avec la recherche d'une diminution des dimensions des transistors, celui de l'établissement des contacts conducteurs sur les diverses électrodes. Ces prises de contact exigent, dans les transistors réalisés par les procédés de photo-masquage, en particulier la prise de contact de drain, des distances de garde notables avec les couches isolantes d'oxyde de silicium et les bords de la grille.

C'est un autre avantage du procédé selon l'invention que de permettre la diminution de ces distances de garde, et par conséquent d'autoriser la possibilité d'une densité d'intégration plus élevée, en faisant assurer la fonction de prise de contact aux régions qui avaient assuré la fonction des sources d'impuretés de dopage à une étape de diffusion antérieure indiquée plus haut.

Un autre mode particulier de réalisation de l'invention est caractérisé en ce qu'il comporte les étapes suivantes :

— création sur une face du substrat de type de conductivité P d'une première couche d'oxyde de silicium et création d'une ouverture dans cette première couche d'oxyde de silicium exposant la surface du substrat,

— dépôt d'une couche de silicium polycristallin dopé par une impureté de type N sur l'ensemble de la face,

— création d'un masque sur une portion de la face du substrat comprenant un bord de l'ouverture de la première couche d'oxyde de silicium et dopage de la portion de la couche de silicium polycristallin non masquée par une impureté de type P ;

— élimination du masque et création d'une deuxième couche d'oxyde de silicium sur la couche de silicium polycristallin et création d'une ouverture commune dans ces deux couches exposant la surface du substrat ;

— création simultanée des régions de source, de drain et de la partie diffusée du canal par diffusion solide des impuretés incluses dans la couche de silicium polycristallin ;

— création sur une troisième couche d'oxyde de silicium produite dans l'ouverture commune pendant cette opération de diffusion, d'une grille de commande ;

— création d'une quatrième couche d'oxyde sur l'ensemble de la face du substrat ;

— création d'ouvertures dans cette quatrième couche d'oxyde de silicium exposant la surface de portions de la couche de silicium polycristallin, et dépôt de prises de contact métalliques avec ces portions sur les régions de source, de drain et sur la grille de commande ;

— la figure 1 représente, suivant une vue en coupe, un transistor N-MOS de structure connue ;

— la figure 2 représente, suivant une vue en coupe, un transistor N-MOS réalisé selon le procédé de l'invention ;

— la figure 3 représente, suivant une vue en coupe, les étapes successives selon l'invention, du procédé de réalisation du transistor correspondant à la figure 2, étapes référencées de (a) à (i).

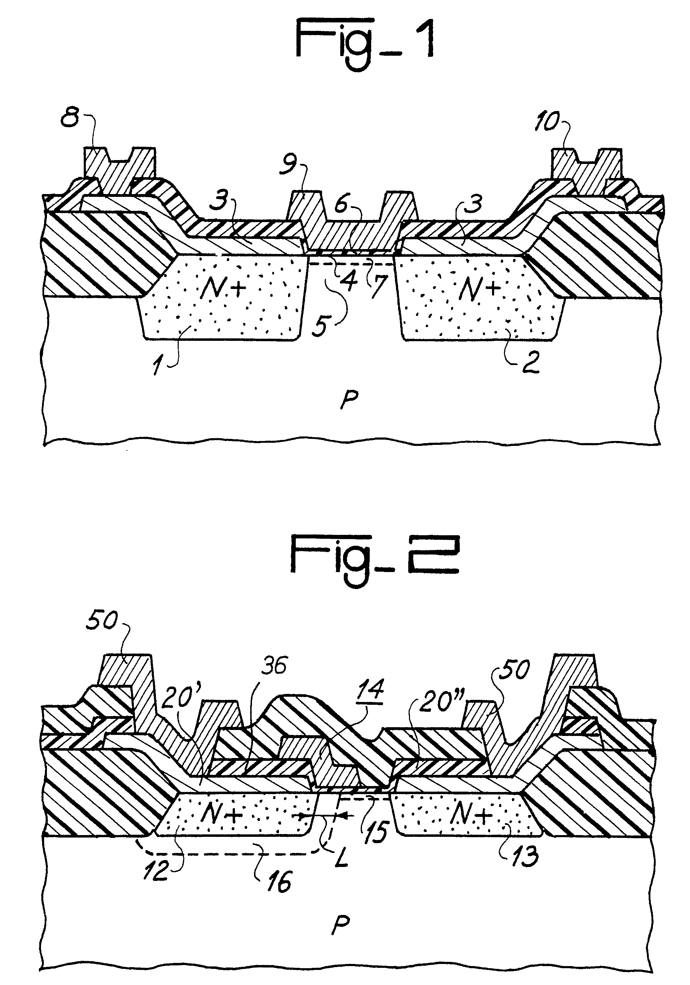

La figure 1 représente un transistor à effet de champ à grille isolée de structure connue suivant une coupe perpendiculaire à la face utile, ou supérieure, du bloc de silicium sur laquelle est réalisé le transistor.

Ce transistor, réalisé dans un bloc-substrat de type de conductivité P, comporte une électrode de source 1, et une électrode de drain 2, constituées par des régions de type N très dopées (N⁺).

Suivant un procédé connu, ces régions sont réalisées par diffusion d'impuretés de type N à partir d'un réservoir constitué par une couche 3 de silicium polycristallin dopé, dans laquelle on a ménagé, par un procédé conventionnel de photomasquage, une ouverture 4 destinée à délimiter la région intermédiaire 5 représentant le canal du transistor.

Par un choix convenable du degré de dopage de cette région, le dépôt d'une couche d'oxyde 6 sur sa surface détermine la formation d'une couche de charges 7 de signe opposé à celui du semiconducteur P, c'est-à-dire de signe N, cette couche étant habituellement désignée sous le nom de couche d'inversion.

Des prises de contact 8, 9 et 10 sont établies sur les régions respectives de source, grille et drain, la prise 9 constituant la grille.

Les régions 3 de silicium polycristallin sont parfaitement adaptées à la prise de contacts sur les régions 1 et 2 qu'elles ont créées, contacts tels que 8 et 10.

Par contre, une telle structure de transistor N-MOS peut difficilement s'accommoder de dimensions inférieures à celles qui correspondent à une longueur de 4 ou 5 μm pour le canal ; en effet, les régions 3 de silicium polycristallin qui en définissent la longueur sont créées par photo-masquage, dont les possibilités de précision atteignent leurs limites pour ces ordres de grandeur.

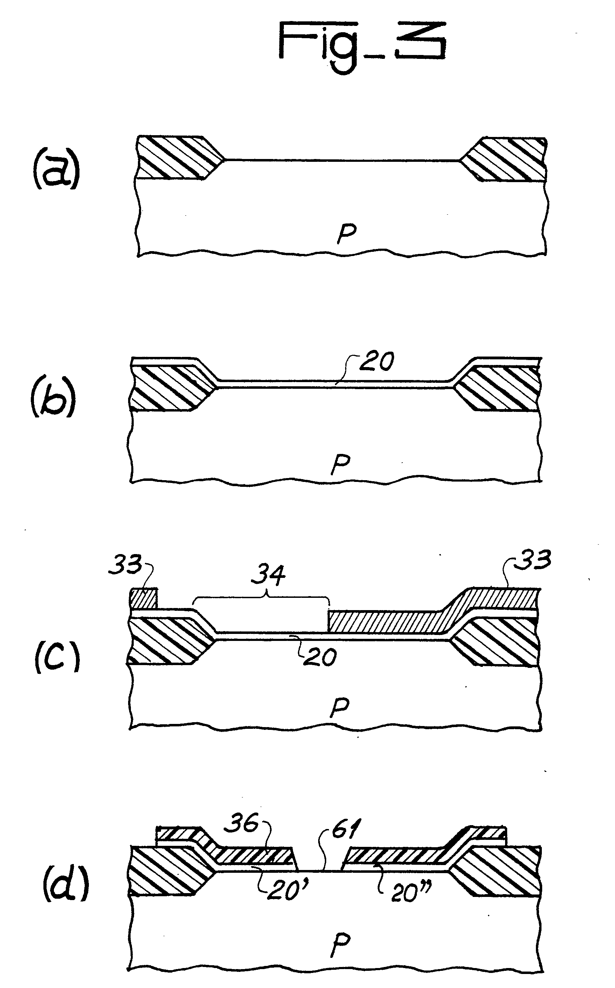

La figure 2 représente un transistor à effet de champ à grille isolée réalisé selon le procédé de l'invention.

Ce transistor comporte une source 12, un drain 13, une grille de commande 14, analogues à ceux du transistor de la figure 1. Cependant, le canal y comporte dans sa longueur deux parties électriquement en série. La partie 15 habituelle, qui représente le canal constitué par la couche d'inversion de charges ; et une autre partie 16, de type de conductivité P, et hautement dopée, qui constitue une première section de canal, de longueur L.

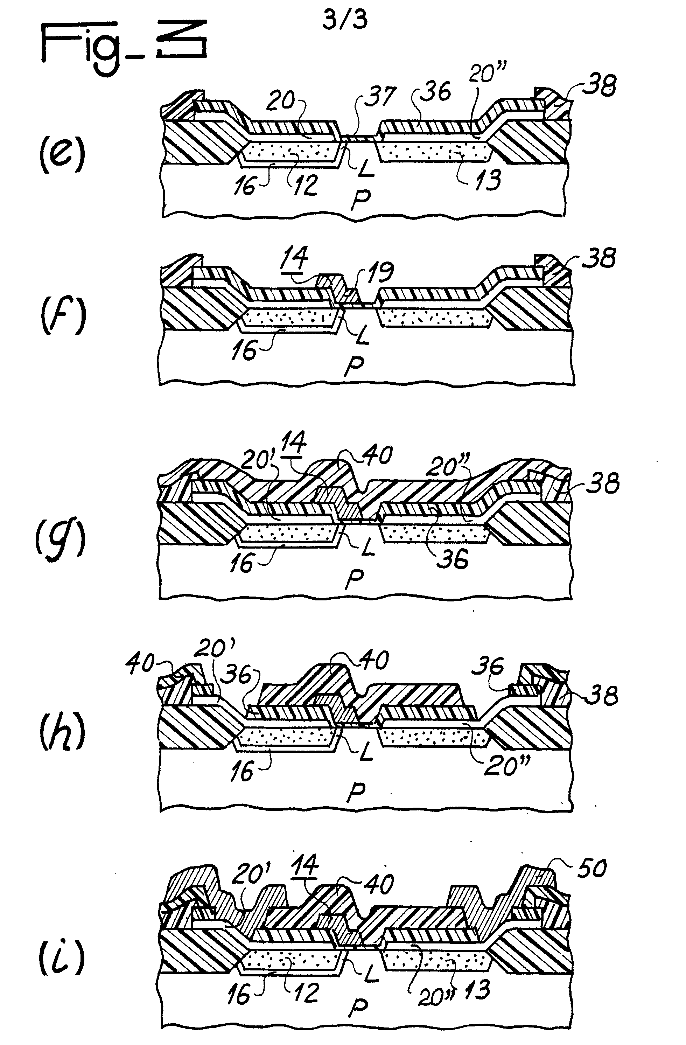

C'est cette section L, en liaison avec la grille 14, qui contrôle essentiellement le passage du courant entre la source et le drain, tandis que le reste du canal, à savoir la couche d'inversion N, se comporte pratiquement comme une région à faible résistivité proche du court-circuit. Il est à noter que l'action de la grille sur cette seconde section est alors négligeable, et en pratique la grille peut se limiter à sa partie 19 (figure 3f), vers la source.

C'est le but de la présente invention que de réaliser un tel transistor, par un procédé permettant de contrôler avec précision la longueur L de la section 16 de type P du canal, et de la réduire à une valeur notablement plus faible que les longueurs de canal réalisées par les procédés existants, typiquement 1 μm.

La figure 3 représente les étapes successives du procédé selon un mode particulier de réalisation de l'invention, suivant une succession de dessins repérés de (a) à (i).

L'étape (a) consiste à créer une première couche d'oxyde de silicium sur un bloc-substrat ou « plaquette » de silicium, et d'y définir la partie de la surface du bloc où le transistor doit être créé, par les procédés de photo-masquage connus.

Dans l'étape (b), la plaquette est recouverte d'une couche de silicium polycristallin (20) dopé avec une impureté de type N telle que l'arsenic, d'environ 300 nm (3 000 Å) d'épaisseur. Cette couche est obtenue par un dépôt en phase vapeur obtenu par décomposition de silane à une température de l'ordre de 700 °C, soit à la pression atmosphérique, soit sous basse pression. Le dopage de la couche est effectué soit pendant le dépôt par rapport du dopant dans l'enceinte de réaction, soit par une implantation ionique à une profondeur inférieure à l'épaisseur de la couche de polycristal.

A l'étape (c), un masque de résine photosensible (33) est ensuite déposé. Il est gravé par un procédé de photogravure conventionnel, avec insolation à travers un masque et un développement pour ouvrir une fenêtre asymétrique 34 s'étendant sur les futures régions de source et de grille. Au travers de celle-ci est réalisée une implantation ionique d'un dopant P, tel que le bore, avec une énergie assurant sa pénétration uniquement dans la couche 20. Le silicium polycristallin de la future zone de source se trouve ainsi simultanément dopé N et P.

La couche 33 est ensuite éliminée, par exemple dans une solution acide ou dans un plasma d'oxygène.

Dans l'étape (d), une deuxième couche d'oxyde (36) de 500 nm (5 000 Å) d'épaisseur est ensuite déposée à basse température, par exemple inférieure à 800°, et gravée par un procédé de photogravure de manière à l'éliminer de la future région du canal et des régions d'oxyde de champ.

Cette couche d'oxyde sert de masque à l'opération d'attaque suivante, qui sert à éliminer la couche de silicium polycristallin 20 dans la région de canal 61. Comme il apparaît sur la figure, cette ouverture est située sur la limite définissant les deux zones respectivement constituées par le poly silicium dopé P et N (20'), et le poly silicium dopé N seulement (20''). Cette attaque peut être faite dans une solution acide ou basique, ou dans un plasma de fréon.

L'étape suivante (e) constitue l'opération fondamentale du procédé selon l'invention.

Elle consiste à porter à haute température la plaquette, à des valeurs typiques comprises entre 800 °C et 1 050 °C, ce qui a pour effet de provoquer une diffusion simultanée des impuretés de dopage contenues dans le silicium polycristallin 20 vers le silicium du substrat. Cette opération permet d'obtenir les régions de drain, de source et de la région P du canal du transistor, respectivement 13, 12 et 16. La région P du canal 16 ne peut être obtenue que si les dopants N et P sont choisis avec des coefficients de diffusion différents. En particulier, pour une structure canal N, le dopant P sera du bore et le N de l'arsenic, afin que le coefficient de diffusion du bore, qui est supérieur à celui de l'arsenic, lui permette de diffuser plus largement en créant la région P de canal 16.

La région de canal apparaît ainsi comme constituée par la « tranche » de la région diffusée, qui débouche sur la surface de la plaquette, et qui définit, par son épaisseur, la longueur L du canal ; la longueur du canal n'est plus liée à l'utilisation de photo-masques géométriques, comme dans les procédés connus, mais simplement à la durée d'un traitement thermique, durée dont le choix permet de définir avec précision la longueur du canal. Les limitations des procédés optiques avec photo-masques sont ainsi surmontées, ce qui conduit à la possibilité d'obtention de canaux de longueur inférieure à 1 μm.

Simultanément il y a oxydation du silicium du substrat dans la région du canal, donnant naissance à l'oxyde d'isolement de grille 37 et recouvrant les couches 36 et 20 d'une couche d'oxyde 38 sur ses flancs latéraux.

A l'étape (f), on crée la grille de commande du transistor.

Elle peut être en métal réfractaire, tel que le molybdène, ou en silicium polycristallin.

Une nouvelle couche de silicium polycristallin dopé N ou P, ou de métal réfractaire, est alors déposée et gravée pour réaliser la grille 14 du transistor MOS ainsi constitué. Comme expliqué plus haut, elle ne recouvre que la portion située au-dessus du canal diffusé, par sa partie 19.

L'étape (g) montre la phase suivante, dans laquelle une couche d'isolement finale 40 est réalisée, constituée de préférence d'un oxyde de silicium dopé au phosphore, dans une proportion telle que, par un traitement thermique ultérieur, cette couche flue et permette un recouvrement d'ensemble aux reliefs plus arrondis. A l'étape (h), cette couche est gravée par des moyens conventionnels de photogravure, afin de présenter des ouvertures pour permettre des prises de contacts sur les régions 20', 20'', et 14 par perçage des couches 36 et 40.

Enfin, à l'étape (i), une couche métallique bonne conductrice 50 constituée par exemple d'aluminium, ou d'un alliage aluminium-silicium, ou d'aluminium-cuivre, est déposée, avec délimitation par photogravure, pour réaliser les prises de contact elles-mêmes sur les couches de silicium polycristallin 20 et 14.

Le procédé de l'invention présente plusieurs importants avantages. On peut d'abord rappeler que le canal du transistor est défini par diffusion et non par photogravure, et que, comme déjà dit, la longueur du canal peut être alors réduite à des valeurs voisines du micron. La structure sera donc rapide, et utilisable pour les transistors UHF, et circuits rapides.

Ensuite les prises de contacts sur le drain et la source sont « autopositionnées », par le fait que le silicium polycristallin sert à la fois de conducteur et de source de dopage des drains et sources.

Cette propriété rend possible la réduction de la surface de ces régions lorsqu'un contact doit y être pris.

Un autre avantage du procédé selon l'invention est de permettre des prises de contact 50 débordant simultanément sur les régions d'oxyde de champ et les régions de source et de drain, ce qui permet une réduction de la surface du drain, tout en conservant des prises de contact suffisantes ; d'où une diminution de la capacité de cette région par rapport au substrat.

Encore un autre avantage du procédé selon l'invention est de rendre indépendants le dopage du drain et le dopage de la grille de commande. La résistivité de celle-ci peut être notablement diminuée, ce qui est intéressant pour diminuer les temps de propagation des signaux lorsque ceux-ci sont transmis par la grille et la couche qui lui est associée.

Cette caractéristique est intéressante dans les circuits de grande surface.

D'autre part, en ce qui concerne les coûts de production, le procédé de l'invention se contente d'un nombre de photogravures identiques au procédé de fabrication du transistor connu représenté sur la figure 1, et dont les inconvénients ont été indiqués plus haut.

Le procédé selon l'invention se présente donc notamment comme mettant en œuvre une couche de silicium polycristallin pour assurer simultanément trois fonctions totalement différentes, dont deux au cours d'une même étape du procédé.

Ces deux dernières fonctions réunissent d'une part la création par diffusion des électrodes de source et de drain d'un transistor, et d'autre part la création par diffusion de son canal. La troisième fonction est celle de connexion de raccordement des source et drain avec les prises de contacts extérieures.

Ainsi, le fait de combiner en un seul procédé la réalisation d'étapes assurant plusieurs fonctions, mises en œuvre séparément antérieurement dans le cadre de procédés différents, constitue une grande amélioration par rapport à l'art connu, en concourant à un but commun de réduction des dimensions des dispositifs obtenus et, de plus, des coûts de production.

**Revendications**

1. Procédé de réalisation d'un transistor à effet de champ à grille isolée, transistor du type comportant une région de source (12) avec son électrode de contact (20'), une région de drain (13) avec son électrode de contact (20") et une région de canal (15, 16) avec une grille de commande (14) isolée par une couche d'oxyde d'isolation de grille (37) au-dessus de la région de canal, procédé qui comporte une étape de création simultanée des régions de source et de drain par diffusion d'impuretés de dopage incluses dans les électrodes de contact, caractérisé en ce que l'une des électrodes de contact (20') comprend des impuretés des deux types de conductivité, et que l'étape de diffusion a une durée déterminée, assurant par différence des vitesses de diffusion des impuretés des deux types, la définition de la longueur (L) d'une partie diffusée (16) du canal, partie qui, en liaison avec la grille de commande (14), contrôle essentiellement le passage du courant.

2. Procédé de réalisation d'un transistor selon la revendication 1, caractérisé en ce que lesdites électrodes de contact (20', 20") sont constituées de silicium polycristallin.

3. Procédé selon la revendication 1 ou 2, caractérisé en ce que l'électrode à deux types d'impuretés de dopage est l'électrode de source (20').

4. Procédé selon l'une des revendications 1 à 3, caractérisé en ce que la grille de commande (14) ne recouvre que la partie diffusée (16) du canal.

5. Procédé selon l'une des revendications 1 à 4, caractérisé en ce que les impuretés de dopage des deux types sont respectivement du bore et de l'arsenic.

6. Procédé selon la revendication 5, caractérisé en ce que le silicium polycristallin des électrodes de contact (20', 20") a été dopé à l'arsenic simultanément avec son dépôt en phase vapeur.

7. Procédé selon la revendication 6, caractérisé en ce que le silicium polycristallin des électrodes de contact (20', 20") a été dopé à l'arsenic par implantation ionique.

8. Procédé selon l'une des revendications 5 à 7, caractérisé en ce que le silicium polycristallin d'une des électrodes de contact est dopé au bore, sur une portion de sa surface délimitée par un masque (33), par implantation ionique.

9. Procédé selon l'une des revendications 1 à 8, caractérisé en ce qu'il comporte une étape de réalisation de grille de commande (14) par dépôt de silicium polycristallin.

10. Procédé selon l'une des revendications 1 à 8, caractérisé en ce qu'il comporte une étape de réalisation de grille de commande (14) par dépôt d'un métal réfractaire.

11. Procédé selon la revendication 10, caractérisé en ce que ledit dépôt est constitué de molybdène.

12. Procédé selon l'une des revendications 1 à 11, caractérisé en ce qu'il comporte les étapes suivantes :
— création sur une face du substrat de type de conductivité P, d'une première couche d'oxyde de silicium et création d'une ouverture dans cette première couche d'oxyde de silicium exposant la surface du substrat (figure 3a) ;
— dépôt d'une couche de silicium polycristallin (20) dopé par une impureté de type N sur l'ensemble de la face (figure 3b) ;
— création d'un masque (33) sur une portion de la face du substrat comprenant un bord de l'ouverture de la première couche d'oxyde de silicium et dopage de la portion de la couche de silicium polycristallin non masquée par une impureté de type P (figure 3c) ;
— élimination du masque (33) et création d'une deuxième couche d'oxyde de silicium (36) sur la couche de silicium polycristallin (20) et création d'une ouverture (61) commune dans ces deux couches (20, 36) exposant la surface du substrat (figure 3d) ;
— création simultanée des régions de source (12), de drain (13) et de la partie diffusée (16) du canal par diffusion solide des impuretés incluses dans la couche de silicium polycristallin (20) (figure 3e) ;
— création sur une troisième couche d'oxyde de silicium (37) produite dans l'ouverture commune (61) pendant cette opération de diffusion, d'une grille de commande (14) (figure 3f) ;
— création d'une quatrième couche d'oxyde (40) sur l'ensemble de la face du substrat (figure 3g) ;
— création d'ouvertures dans cette quatrième couche d'oxyde de silicium (40) exposant la surface de portions de la couche de silicium polycristallin (20', 20"), et dépôt de prises de contact (50) métalliques avec ces portions sur les régions de source, de drain et sur la grille de commande (14) (figures 3h et 3i).

## Claims

1. Method of producing an insulated gate field effect transistor comprising a source region (12) having its contacting electrode (20'), a drain region (13) having its contacting electrode (20") and a channel region (15, 16) having a control gate (14) insulated by a gate insulating oxide layer (37) above the channel region, the method comprising a step of simultaneously forming the source and drain regions by diffusion of doping impurities included within the contacting electrodes, characterized in that one of the contacting electrodes (20') comprises impurities of the two conductivity types, and that the diffusion step has a predetermined duration assuring, by the diffusion speed difference of the impurities of the two types, the definition of the length (L) of a diffused portion (16) of the channel, said portion essentially controlling the current flow, in connection with the control gate (14).

2. Method of producing a transistor in accordance with claim 1, characterized in that the said contacting electrodes (20', 20") are formed of polycristalline silicon.

3. Method in accordance with claim 1 or 2, characterized in that the electrode having two types of doping impurities is the source electrode (20').

4. Method in accordance with any of claims 1 to 3, characterized in that the control gate (14) covers only the diffused portion (16) of the channel.

5. Method in accordance with any of claims 1 to 4, characterized in that the doping impurities of the two types are boron and arsenic, respectively.

6. Method in accordance with claim 5, characterized in that the polycristalline silicon of the contacting electrodes (20', 20") was doped with arsenic simultaneously with its vapour phase deposition.

7. Method of claim 6, characterized in that the polycristalline silicon of the contacting electrodes (20', 20") was doped with arsenic by ion implantation. ,

8. Method of any of claims 5 to 7, characterized in that the polycristalline silicon of one the contacting electrodes is boron doped by ion implantation on a portion of its surface defined by a mask (33).

9. Method of any of claims 1 to 8, characterized in that it comprises a step of forming the control gate (14) by polycristalline silicon deposition.

10. Method of any of claims 1 to 8, characterized in that it comprises a step of forming the control gate (14) by deposition of a refractory metal.

11. Method of claim 10, characterized in that said deposition is formed of molybdenum.

12. Method of any of claims 1 to 11, characterized in that it comprises the following steps :

— forming a first silicon oxide layer on one face of the substrate of P conductivity type and forming an opening in said first silicon oxide layer exposing the substrate surface (Figure 3a) ;

— deposition of a polycristalline silicon layer (20) doped by an N type impurity, on the total face (Figure 3b) ;

— forming a mask (33) on a portion of the substrate face comprising an edge of the opening of the first silicon oxide layer and doping of the unmasked portion of the polycristalline silicon layer by a P type impurity (Figure 3c) ;

— elimination of the mask (33) and forming a second silicon oxide layer (36) on the polycristalline silicon layer (20) and forming a common opening (6) in the two layers (20, 36) exposing the substrate surface (Figure 3d) ;

— simultaneously forming the source (12) and drain (13) regions and the diffused portion (16) of the channel by solid diffusion of the impurities included within the polycristalline silicon layer (20) (Figure 3e) ;

— forming a control gate (14) on a third silicon oxide layer (37) produced in the common opening (61) during said diffusion operation (Figure 3f) ;

— forming a fourth oxide layer (40) on the total face of the substrate (Figure 3g) ;

— forming of openings in said fourth silicon oxide layer (40) exposing the surface of portions of the polycristalline silicon layer (20', 20") and deposition of metallic contacting terminals (50) with said portions on the source and drain regions and on the control gate (14) (Figures 3h and 3i).

## Ansprüche

1. Verfahren zur Herstellung eines Feldeffekttransistors mit isolierter Steuerelektrode, wobei der Transistor solcher Art ist, daß er einen Sourcebereich (12) mit seiner Kontaktelektrode (20), einen Drainbereich (13) mit seiner Kontaktelektrode (20") und einen Kanalbereich (15, 16) mit einem Steuergate (14) aufweist, das durch eine Gateisolierungs-Oxidschicht (37) über dem Kanalbereich isoliert ist, wobei das Verfahren einen Verfahrensschritt zur gleichzeitigen Herstellung der Source- und Drainbereiche durch Diffusion von Dotierungsverunreinigungen umfaßt, die in den Kontaktelektroden enthalten sind, dadurch gekennzeichnet, daß die eine der Kontaktelektroden (20') Verunreinigungen der beiden Leitungstypen umfaßt und daß der Diffusionsschritt eine bestimmte Dauer hat, die durch den Unterschied der Diffusionsgeschwindigkeiten der Verunreinigungen der beiden Arten die Festlegung der Länge (L) eines diffundierten Teiles (16) des Kanals gewährleistet, wobei dieser Teil in Verbindung mit dem Steuergate (14) im wesentlichen den Stromdurchgang steuert.

2. Transistorherstellungsverfahren nach Anspruch 1, dadurch gekennzeichnet, daß die Kontaktelektroden (20', 20") aus polykristallinem Silizium gebildet sind.

3. Verfahren nach Anspruch 1 oder 2, dadurch gekennzeichnet, daß die zweierlei Arten von Dotierungsverunreinigungen aufweisende Elektrode die Sourceelektrode (20') ist.

4. Verfahren nach einem der Ansprüche 1 bis 3, dadurch gekennzeichnet, daß das Steuergate (14) nur den diffundierten Teil (16) des Kanals überdeckt.

5. Verfahren nach einem der Ansprüche 1 bis 4, dadurch gekennzeichnet, daß die Dotierungsverunreinigungen der beiden Arten Bor bzw. Arsen sind.

6. Verfahren nach Anspruch 5, dadurch gekennzeichnet, daß das polykristalline Silizium der Kontaktelektroden (20', 20") gleichzeitig mit seiner Ablagerung in der Dampfphase mit Arsen dotiert wurde.

7. Verfahren nach Anspruch 6, dadurch gekennzeichnet, daß das polykristalline Silizium der Kontaktelektroden (20', 20") durch Ionenimplantation mit Arsen dotiert wurde.

8. Verfahren nach einem der Ansprüche 5 bis 7, dadurch gekennzeichnet, daß das polykristalline Silizium einer der Kontaktelektroden auf einem Teil ihrer Oberfläche, der durch eine Maske (33) abgedeckt wird, durch Ionenimplantation mit Bor dotiert wird.

9. Verfahren nach einem der Ansprüche 1 bis 8, dadurch gekennzeichnet, daß es eine Stufe zur Herstellung des Steuergates (14) durch Ablagerung von polykristallinem Silizium umfaßt.

10. Verfahren nach einem der Ansprüche 1 bis 8, dadurch gekennzeichnet, daß es eine Stufe zur Herstellung des Steuergates (14) durch Ablagerung eines hitzebeständigen Metalls umfaßt.

11. Verfahren nach Anspruch 10, dadurch gekennzeichnet, daß die Ablagerung aus Molybdän gebildet ist.

12. Verfahren nach einem der Ansprüche 1 bis 11, dadurch gekennzeichnet, daß es folgende Schritte umfaßt :

— Bildung einer ersten Siliziumoxidschicht auf einer Fläche des Substrats vom Leitungstyp P und Bildung einer Öffnung in dieser ersten Siliziumoxidschicht, welche die Substratoberfläche freilegt (Fig. 3a) ;

— Ablagerung einer polykristallinen Siliziumschicht (20), die mit einer Verunreinigung vom N-Typ dotiert ist, auf der gesamten Fläche (Fig. 3b) ;

— Bildung einer Maske (33) auf einem Substratflächenteil, der einen Rand der Öffnung der ersten Siliziumoxidschicht enthält, und Dotierung des nicht abgedeckten Teils der polykristallinen Siliziumschicht durch eine Verunreinigung vom P-Typ (Fig. 3c) ;

— Entfernen der Maske (33) und Bildung einer zweiten Siliziumoxidschicht (36) auf der polykristallinen Siliziumschicht (20) und Bildung einer in den beiden Schichten (20, 36) gemeinsamen Öffnung (6), welche die Substratoberfläche freilegt (Fig. 3d) ;

— Gleichzeitige Herstellung des Source-Bereiches (12), des Drain-Bereiches (13) und des diffundierten Teils (16) des Kanals durch Feststoffdiffusion der in der polykristallinen Siliziumschicht (20) enthaltenen Verunreinigungen (Fig. 3e) ;

— Bildung eines Steuergates (14) auf einer dritten Siliziumoxidschicht (37), die in der gemeinsamen Öffnung (61) während dieses Diffusionsschrittes gebildet wurde (Fig. 3f) ;

— Bildung einer vierten Oxidschicht (40) auf der gesamten Substratfläche (Fig. 3g) ;

— Bildung von Öffnungen in dieser vierten Siliziumoxidschicht (40), welche die Oberfläche von Teilen der polykristallinen Siliziumschicht (20', 20") freilegen, und Ablagerung von Metall-Kontaktanschlüssen (50) an diesen Teilen am Source- und Drain-Bereich und an dem Steuergate (14) (Fig. 3h und 3i).

Fig_1

Fig_2

# Fig_3

Fig_III

(e)

20  37  36  20"  38

16  12  L  13
        P

(f)

14  19  38

16  L
     P

(g)

20'  14  40  20"  38

16  L  36
     P

(h)

40  20'  36  40  36  38

16  L  20"
     P

(i)

20'  14  40  50

16  12  L  20"  13
        P